# EUROPEAN PATENT SPECIFICATION

(11) **EP 3 598 584 B1**
(45) Date of publication and mention of the grant of the patent: **29.12.2021**
(21) Application number: 18767909.7
(22) Date of filing: 27.02.2018
(51) Int. Cl.: H01R 13/15, G01D 11/24, G01L 19/14, G01P 15/08, H01R 13/66

(54) **ELECTRONIC DEVICE HAVING FIXED CONDUCTIVE PLATE AND FLEXIBLE CONDUCTIVE PLATE**
ELEKTRONISCHE VORRICHTUNG MIT EINER FESTEN LEITFÄHIGEN PLATTE UND EINER FLEXIBLEN LEITFÄHIGEN PLATTE
DISPOSITIF ÉLECTRONIQUE AYANT UNE PLAQUE CONDUCTRICE FIXE ET UNE PLAQUE CONDUCTRICE FLEXIBLE

(30) Priority: 14.03.2017 JP 2017048149
(43) Date of publication of application: 22.01.2020
(73) Proprietor: Alps Alpine Co., Ltd., Tokyo 1458501 (JP)
(72) Inventor: WAGA, Satoshi, Tokyo 145-8501 (JP); NAKAYAMA, Keisuke, Tokyo 145-8501 (JP); HOSOGOE, Junichi, Tokyo 145-8501 (JP); KIKUCHI, Shinji, Tokyo 145-8501 (JP); SUZUKI, Kazuhiko, Tokyo 145-8501 (JP)
(74) Representative: Schmitt-Nilson Schraud Waibel Wohlfrom Patentanwälte Partnerschaft mbB
(86) International application number: PCT/JP2018/007081
(87) International publication number: WO 2018/168424

(56) References cited:
- EP-A1- 1 584 911
- WO-A1-2011/158801
- JP-A- H1 032 107
- JP-A- 2001 004 365
- JP-U- H0 199 006
- US-A- 5 856 774
- US-A1- 2012 289 091

## Description

### Technical Field

The present invention relates to an electronic device in which fixed conductive plates and elastic conductive plates pressed elastically against fixed electrode portions provided on a circuit board or the like on which a physical quantity sensor is mounted are provided in a case.

### Background Art

An invention related to an electronic part in which external terminals (fixed conductive plates) and internal terminals (elastic conductive plates) are provided in a cabinet 1 is described in PTL 1.

In this electronic part, an external terminal 2 fixed in the cabinet 1 is provided, and a flat portion 2a and an opposing portion 2f, which face each other by bending the external terminal 2, are formed. An internal terminal 3, which can be elastically deformed, is attached between the flat portion 2a and opposing portion 2f of the external terminal 2. A flat portion 3a, a first elastic portion 3b bent from the flat portion 3a, and an abutting portion 3c at the top of the first elastic portion 3b are formed integrally with the internal terminal 3. The flat portion 3a is elastically in contact with the flat portion 2a of the external terminal 2, and the abutting portion 3c is elastically in contact with the opposing portion 2f of the external terminal 2. A 180-degree turn-back portion is provided at the top of the flat portion 3a of the internal terminal 3. A second elastic portion 3d extends from the turn-back portion. A contact point 3e at the top of the second elastic portion 3d is elastically in contact with a resistive pattern 4a on the front surface of an insulated substrate 4.

Also, a stopper portion 3f, which is cut from the flat portion 3a and is raised, is formed integrally with the internal terminal 3. This stopper portion 3f is engaged with a concave portion 2b formed in the external terminal 2 or with a concave portion 1t formed in a side wall of the cabinet 1 to prevent the internal terminal 3 from coming off.

### Citation List

### Patent Literature

PTL 1: Japanese Unexamined Patent Application Publication No. 10-32107

### Summary of Invention

### Technical Problem

In the electronic part described in PTL 1, the stopper portion 3f, which is cut from the flat portion 3a of the internal terminal 3 and is raised, is engaged with the concave portion 2b or concave portion 1t to prevent the internal terminal from coming off. However, this engagement between the stopper portion 3f and the concave portion alone cannot adequately prevent the internal terminal 3 from coming off. To increase the coming off prevention effect, it is necessary to form the stopper portion 3f in such a way that it becomes long. As a result, a problem arises in that the internal terminal 3 becomes larger than necessary.

Also, in the electronic part described in PTL 1, the top of the flat portion 3a of the internal terminal 3 is turned back 180 degrees as indicated in Fig. 3 and Fig. 4 in PTL 1. By providing this 180-degree turn-back portion, the position of the base end of the internal terminal 3 extending from the turn-back portion is determined. In this structure, however, when a force is exerted on the second elastic portion 3d, stress concentrates on the 180-degree turn-back portion. This is likely to become a cause of fatigue.

US 5 856 774 A shows in an electrical part, a first resilient portion of an internal terminal being inserted into a terminal guide portion, and the internal terminal is inserted into the terminal guide portion such that a contact portion thereof resiliently contacts the inner side of the terminal guide portion. A curved second contact portion of the internal terminal is formed at one end, and a stopper, disposed at the internal terminal, is retained in a recess of an external terminal to prevent the internal terminal from being removed from the terminal guide groove.

The present invention addresses the above conventional problem with the object of providing an electronic device, having fixed conductive plates and elastic conductive plates, that can increase the effect of preventing the elastic conductive plates from coming off.

Another object of the present invention is to provide an electronic device, having fixed conductive plates and elastic conductive plates, that can determine the position of the base end of an elastic arm portion without forming a 180-degree turn-back portion on the elastic conductive plate and can optimally set an elastic force between an elastically-pressed contact point and a fixed electrode portion.

### Solution to Problem

According to the invention an electronic device according to claim 1 is provided.

The electronic device, in the present invention, that has the fixed conductive plate and elastic conductive plate can be structured so that a hole is formed in the support piece portion and that, in the restricting portion, the linkage end is fitted into the hole.

For example, the plate thickness of the linkage end is small and a portion, of the linkage end, that has the small plate thickness is fitted into the hole.

The electronic device, in the present invention, that has the fixed conductive plate and elastic conductive plate can be structured so that at least one stop piece is formed by being cut and raised in the support piece portion and that, in the restricting portion, the top of the stop piece is stopped at the linkage end inserted into the hole.

Also, in the electronic device, in the present invention, that has the fixed conductive plate and elastic conductive plate, it is preferable that a concave portion opposite to the linkage end be formed in the case and that the top of the linkage end be inserted into the concave portion.

### Advantageous Effects of Invention

In the electronic device in the present invention, a first pressure contact portion, a second pressure contact portion, a support piece portion bent from the second pressure contact portion, and an elastic arm portion bent from the support piece portion are formed for an elastic conductive plate. In a restricting portion, the elastic conductive plate and support piece portion are fitted to each other to restrict the support piece portion from separating from a fixed electrode portion. Therefore, it becomes possible to effectively restrict the elastic conductive plate from coming off a clearance between a first contact surface and a second contact surface.

Since, in the electronic device in the present invention, the support piece portion is restricted and fixed in the restricting portion, the base end (support end) of the elastic arm portion, which is a cantilever beam, can be set in a place that substantially matches the bending boundary portion between the support piece portion and the elastic arm portion. Since the base end (support end) of the elastic arm portion can be determined, the working lengths of elastic arm portions can be easily made uniform and a pressure contact force between an elastically-pressed contact portion and the fixed electrode portion can be optimally set. In addition, since a 180-degree turn-back portion or the like is not necessary, concentration of stress on the base end (support end) of the elastic arm portion can be mitigated and accumulation of fatigue can thereby be reduced.

### Brief Description of Drawings

[Fig. 1] Fig. 1 is a cross-sectional view indicating an electronic device in a first embodiment of the present invention.
[Fig. 2] Fig. 2 is a partially enlarged view of the cross-sectional view of the electronic device in the first embodiment indicated in Fig. 1.
[Fig. 3] Fig. 3 is an exploded perspective view indicating the structure of the electronic device in the first embodiment indicated in Fig. 1, the drawing including a partial sectional-view.
[Fig. 4] Fig. 4 is an exploded perspective view indicating fixed conductive plates and elastic conductive plates provided in the electronic device in the first embodiment indicated in Fig. 1.
[Fig. 5] Fig. 5 is a partially enlarged view of a cross-sectional view of an electronic device in a second embodiment.
[Fig. 6] Fig. 6 is a partially enlarged view of a cross-sectional view of an electronic device in a third embodiment.

### Description of Embodiments

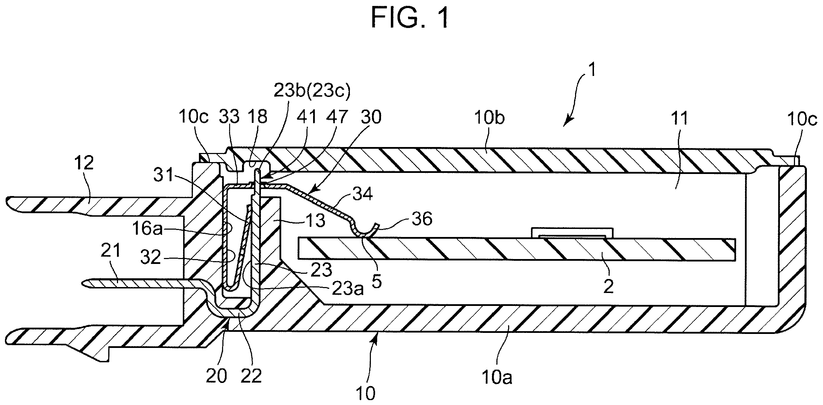

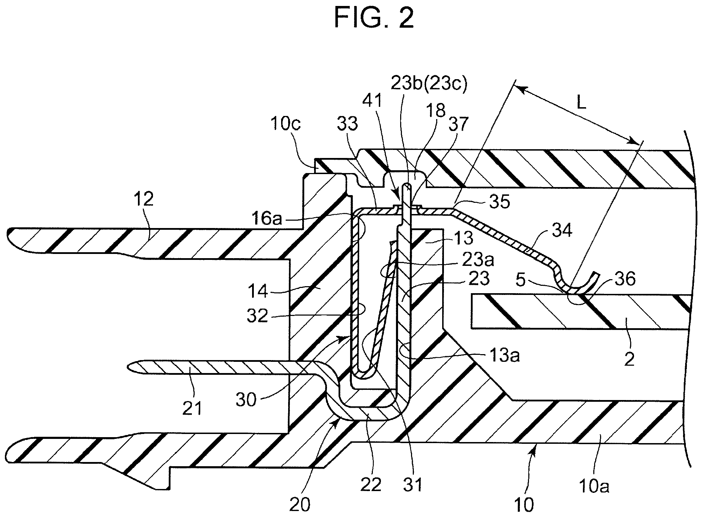

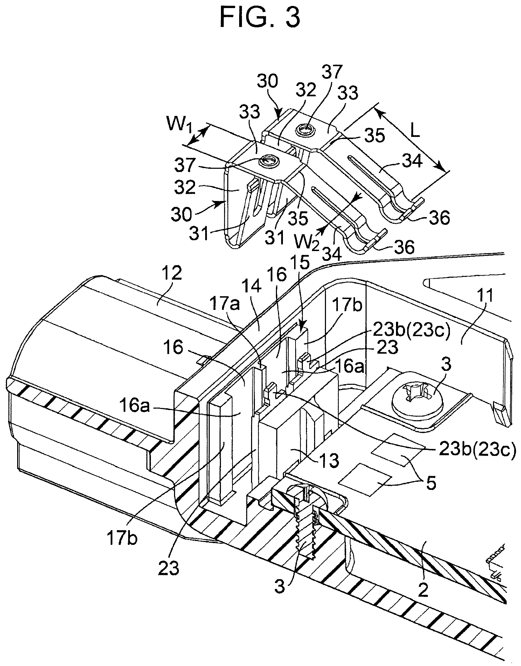

In Fig. 1 and Fig. 2, a cross-sectional view of an electronic device 1 in a first embodiment of the present invention is indicated. In Fig. 3, an exploded perspective view indicating a partial cross-section is indicated.

In this electronic device 1, a circuit board 2 is accommodated in internal space 11 in a case (cabinet) 10. As indicated in Fig. 3, the circuit board 2 is fixed to the case 10 with fixing screws 3. On the circuit board 2, an acceleration sensor is mounted as a physical quantity sensor. Alternatively, the physical quantity sensor may be a pressure sensor, a humidity sensor, an angular velocity sensor, or the like. The electronic device 1 is for use in a vehicle. The electronic device 1 is attached to, for example, the axle, its support portion, or the like and is used for detection of acceleration exerted on the vehicle body. Therefore, the electronic device 1 is needed to be structured so that even if large acceleration is exerted, a contact failure or the like is not caused in the internal structure.

The case 10 is made of a synthetic resin. The case 10 is structured by combining a first case 10a forming the internal space 11 and a second case 10b, in a cover body structure, that covers the opening portion of the internal space 11. The edge 10c of the second case 10b is bonded and fixed to the opening end of the first case 10a. Alternatively, the edge 10c is fixed by screwing or laser welding.

As indicated in Fig. 1, Fig, 2, and Fig. 3, a connector portion 12 in a hollow shape is integrally formed on the left side, in the drawing, of the first case 10a. Fixed conductive plates 20 are buried in the first case 10a. The first case 10a is injection-molded from a synthetic resin. During this molding, the fixed conductive plates 20 are inserted into a mold and the first case 10a and fixed conductive plates 20 are integrated together by so-called insert-molding. However, the fixed conductive plates 20 may be fixed by, for example, being inserted into the first case 10a that has been already molded.

The fixed conductive plate 20 is formed from a conductive metal plate such as brass. The fixed conductive plate 20 has an external terminal portion 21. The external terminal portion 21 protrudes from the first case 10a into the interior of the connector portion 12. As for the fixed conductive plate 20, the base of the external terminal portion 21 and a bent bottom 22, which is bent from the base in the downward direction in the drawings, are buried in the first case 10a.

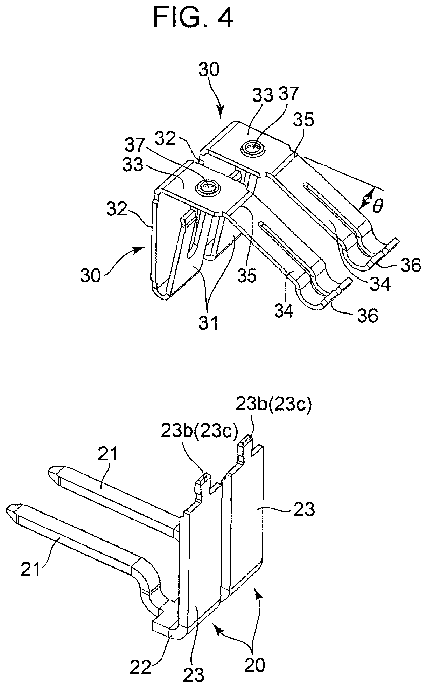

As indicated in Fig. 1, Fig, 2, and Fig. 3, an inner wall portion 13 erected from the bottom side in the drawings toward the internal space 11 is formed integrally with the first case 10a. As indicated in Fig. 3 and Fig. 4, a contact plate portion 23 bent from the bent bottom 22 substantially at right angles is provided for the fixed conductive plate 20. The contact plate portion 23 is placed in tight contact with an opposing inner surface 13a of the inner wall portion 13 and is supported.

As indicated in Fig. 3, the first case 10a has a peripheral wall portion 14 continuous to the connector portion 12. A peripheral wall support portion 15 opposite to the inner wall portion 13 is formed integrally with an inner wall, facing the internal space 11, of the peripheral wall portion 14. A pair of holding concave portions 16 and 16 extending in the up-and-down direction is formed in the peripheral wall support portion 15. A partitioning rib 17a extending in the up-and-down direction is integrally formed between the two holding concave portions 16 and 16. Partitioning ribs 17b and 17b extending in the up-and-down direction are integrally formed at the side portion of each holding concave portion 16 as well.

As indicated in Fig. 1 and Fig. 2, a plate surface of the fixed conductive plate 20, the plate surface being the front surface of the contact plate portion 23, is a first contact surface 23a, and the front surface of the holding concave portion 16 is a second contact surface 16a. In the internal space 11 of the case 10, the first contact surface 23a and second contact surface 16a are opposite to each other in parallel. In this embodiment, the first contact surface 23a is the front plate surface of the contact plate portion 23 of the fixed conductive plate 20, and the second contact surface 16a is the front surface of a synthetic resin material forming the case 10. Contrary to this embodiment, however, the first contact surface may be the front surface of the inner wall portion 13, and the second contact surface may be the front plate surface of the fixed conductive plate 20 positioned in the holding concave portion 16. Alternatively, both the first contact surface and second contact surface may be the front plate surface of the fixed conductive plate 20.

In the internal space 11 of the case 10, an opposing portion of the first contact surface 23a and second contact surface 16a is accommodation space for an elastic conductive plate 30. The elastic conductive plate 30 is formed from a leaf spring metal material such as stainless steel or beryllium copper. As indicated in Fig. 3 and Fig. 4, the elastic conductive plate 30 is bent in a V-shape, forming a first pressure contact portions 31 and a second pressure contact portions 32. The elastic conductive plate 30 is inserted into the case 10 while the bent portion between the first pressure contact portion 31 and the second pressure contact portion 32 faces downward. Due to this, a pair of elastic conductive plates 30 is attached in the accommodation space. When each of the pair of elastic conductive plates 30 is attached in the accommodation space in the first case 10a, the first pressure contact portion 31 is elastically pressed against the first contact surface 23a and the second pressure contact portion 32 is elastically pressed against the second contact surface 16a. Since the first contact surface 23a is the front plate surface of the fixed conductive plate 20, the fixed conductive plate 20 and elastic conductive plate 30 are electrically continuous to each other on the first contact surface 23a.

As for the fixed conductive plate 20 and elastic conductive plate 30, a gold-plated layer is formed at least on the front surface of a conductive contact portion. The gold-plated layer is formed on the front surface of a substrate layer such as nickel.

As indicated in Fig. 3 and Fig. 4, a support piece portion 33, which is bent from the top of the second pressure contact portion 32 substantially at right angles, is integrally provided for each elastic conductive plate 30. As indicated in Fig. 1 and Fig. 2, the support piece portion 33 passes through an opposing portion between the contact plate portion 23 forming the first contact surface 23a and the second case 10b, passes the first contact surface 23a, and extends toward the interior of the internal space 11.

An elastic arm portion 34 integrally extends from the support piece portion 33. The elastic arm portion 34 is bent downward with the boundary portion 35 between the support piece portion 33 and the elastic arm portion 34 taken as a bending portion, and the top of the elastic arm portion 34 is an elastically-pressed contact point 36, which is deformed in a concavely curved surface shape. The elastic arm portion 34 extends toward the fixed electrode portion 5 provided on the front surface of the circuit board 2 indicated in Fig. 3, and the elastically-pressed contact point 36 is elastically pressed against the fixed electrode portion 5.

As indicated in Fig. 3, the width dimension W2 of the elastic arm portion 34 is thinner than the width dimension W1 of the support piece portion 33. The width dimension changes in steps at the boundary portion 35. As for the elastic conductive plate 30, therefore, the stiffness of the elastic arm portion 34 is lower than the stiffness of the support piece portion 33 in steps at the boundary portion 35. The working length L of the elastic arm portion 34, which functions as a cantilever beam, is a length from the boundary portion 35, which is the bending portion, to the contact point between the elastically-pressed contact point 36 and the fixed electrode portion 5.

As indicated in Fig. 1, Fig. 2, Fig. 3, and Fig, 4, a thin plate portion 23b, the plate thickness dimension of which is deformed and reduced by pressure molding, is formed at the top of the contact plate portion 23 of the fixed conductive plate 20. This thin plate portion is a linkage end 23c. A hole 37 is formed in the support piece portion 33 of the elastic conductive plate 30 by a so-called burring process. A restricting portion 41 is formed by fitting the thin plate portion 23b (linkage end 23c) at the top of the contact plate portion 23 and the hole 37 to each other. The restricting portion 41 prevents the support piece portion 33 of the elastic conductive plate 30 from being deformed in a direction away from the fixed electrode portion 5 (a direction away from the circuit board 2) and also prevents the support piece portion 33 from moving.

As indicated in Fig. 2, a concave portion 18 is formed in the lower surface of the second case 10b. The top of the thin plate portion 23b is inserted into the concave portion 18. Even if the fitting between the thin plate portion 23b and the hole 37 is loosened due to the exertion of unexpected acceleration or the like, the support piece portion 33 that begins to be deformed in the upward direction in the drawing abuts the lower surface of the second case 10b without detachment between the thin plate portion 23b and the hole 37. Therefore, even if the support piece portion 33 is raised in the upward direction in the drawing, plastic deformation can be prevented.

The electronic device 1 in the first embodiment is mounted on the axle of a vehicle, its support portion, or the like, and the acceleration of the vehicle body is detected by an acceleration sensor mounted on the circuit board 2. Alternatively, various types of information may be detected by other physical quantity sensors. Detection signals of the acceleration sensor and the like undergo information processing by an IC or the like mounted on the circuit board 2. The elastically-pressed contact points 36 of a pair of elastic conductive plates 30 are each elastically pressed against the fixed electrode portion 5, and the signal that has undergone information processing is transmitted from a conductive pattern on the circuit board through the fixed electrode portion 5 to the elastic conductive plate 30. Furthermore, as for the elastic conductive plate 30, since the first pressure contact portion 31 is in contact with the contact plate portion 23 of the fixed conductive plate 20, the signal that has undergone information processing is given from the pair of elastic conductive plates 30 to a pair of fixed conductive plates 20. A plug is fitted into the connector portion 12 of the case 10.

As for the fixed conductive plate 20 and elastic conductive plate 30, in the restricting portion 41, the thin plate portion 23b (linkage end 23c) at the top of the contact plate portion 23 is fitted into the hole 37 formed in the support piece portion 33 as indicated in Fig. 1 and Fig. 2. The dimensions of the thin plate portion 23b are set so that it can be forcibly press-fitted into the hole 37. With a fitting force due to the press-fitting, the elastic conductive plate 20 is held so that it does not easily move in the upward direction in the drawings from the fitting state indicated in Fig. 2.

As indicated in Fig. 3, the width dimension W1 of the support piece portion 33 of the elastic conductive plate 30 is larger than the width dimension of the elastic arm portion 34, so a step with the width dimension is provided at the boundary portion 35 between the support plate portion 33 and the elastic arm portion 34. In addition, the support plate portion 33 is strongly held in the restricting portion 41 so that the support plate portion 33 is not separated from the fixed electrode portion 5 in the upward direction in the drawing. Therefore, the elastic deformation of the support piece portion 33 is suppressed and the elastic arm portion 34 functions as a cantilever beam having the length L from the boundary portion 35 to the elastically-pressed contact point 36 as an essential working length.

With the elastic conductive plate 30, a bending angle between the second pressure contact portion 32 and the support piece portion 33 is approximately 90 degrees. As indicated in Fig. 4, the bending angle θ of the elastic arm portion 34 from the support piece portion 33 is 90 degrees or less and is 45 degrees or less, and a 180-degree turn-back portion as described in PTL 1 is not provided. As for the elastic conductive plate 30, the working length L of the elastic arm portion 34 can be determined, so it becomes easy to appropriately set an elastic force with which the elastically-pressed contact point 36 of the elastic arm portion 34 is elastically pressed against the fixed electrode portion 5. Since the elastic conductive plate 30 does not have a large turn-back portion, it becomes possible to prevent large stress from concentrating on the base end (support end: that is, boundary portion 35) of the elastic arm portion 34.

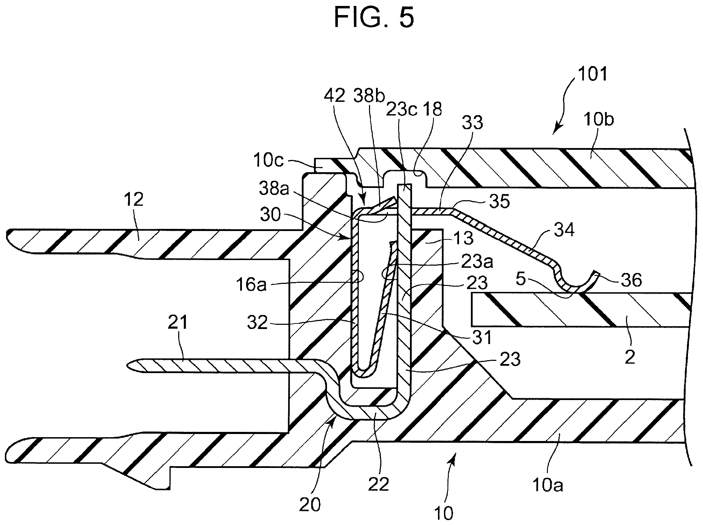

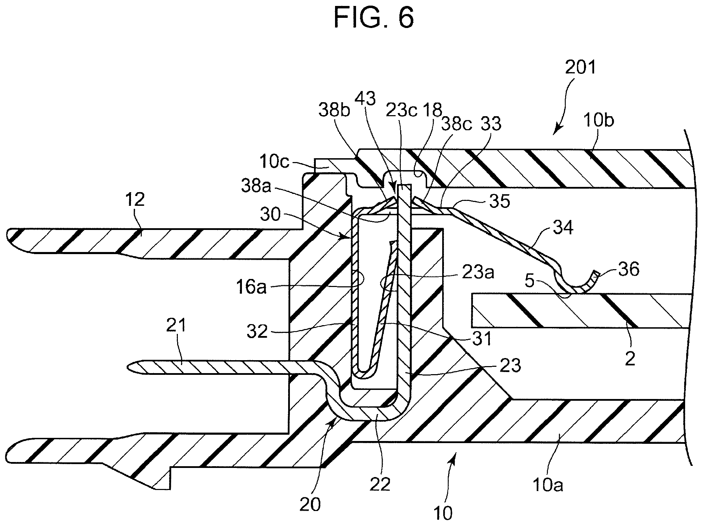

In Fig. 5 and Fig. 6, electronic devices in a second embodiment and a third embodiment of the present invention are indicated. In Fig. 5 and Fig. 6, structural portions that are the same as in the first embodiment will be given the same reference characters and detailed descriptions will be omitted.

In the electronic device 101, indicated in Fig. 5, in the second embodiment of the present invention, a hole 33a and a stop piece 38b, which is cut upward from the hole 33a, are formed integrally with the support piece portion 33 of the elastic conductive plate 30. The linkage end 23c, which is the top of the contact plate portion 23 of the fixed conductive plate 20, is inserted into the hole 38a and the edge at the top of the stop piece 38b is elastically pressed against the linkage end 23c and is stopped, forming a restricting portion 42 that prevents the support piece portion 33 from being deformed in a direction away from the fixed electrode portion 5 and also prevents the support piece portion 33 from moving.

In the electronic device 201, indicated in Fig. 6, in the third embodiment of the present invention, a pair of stop pieces 38b and 38c, which extend in mutually opposite directions, is formed in the hole 33a in the support piece portion 33. The edges at the tops of the stop pieces 38b and 38c are elastically pressed against and are fitted to the front surfaces on both sides of the linkage end 23c inserted into the hole 33a, forming a restricting portion 43.

Also, as indicated in Fig. 5 and Fig. 6, the concave portion 18 is formed in the lower surface of the second case 10b, and the upper end of the linkage end 23c is inserted into the concave portion 18. Therefore, even if unexpected acceleration is exerted, the support piece portion 33 does not come off the linkage end 23c.

### Reference Signs List

- 1, 101, 201: electronic device
- 2: circuit board
- 5: fixed electrode portion
- 10: case
- 10a: first case
- 10b: second case
- 11: internal space
- 13: inner wall portion
- 13b: restricting opposing portion
- 16: holding concave portion
- 16a: second contact surface
- 19: restricting support portion
- 20: fixed electrode plate
- 21: external terminal portion
- 23: contact plate portion
- 23a: first contact surface
- 23b: thin plate portion (linkage end)
- 23c: linkage end
- 30: elastic conductive plate
- 31: first pressure contact portion
- 32: second pressure contact portion
- 33: support piece portion
- 34: elastic arm portion
- 35: boundary portion
- 36: elastically-pressed contact point
- 37: hole
- 41, 42, 43: restricting portion

## Claims

1. An electronic device (1, 101, 201), having a fixed conductive plate (20) and an elastic conductive plate (30), in which the fixed conductive plate (20), part of which becomes an external terminal portion (21), the elastic conductive plate (30) connected to the fixed conductive plate (20), and a fixed electrode portion (5) that is electrically continuous to the elastic conductive plate (30) are provided in a case (10);
a first contact surface (23a) and a second contact surface (16a), which are opposite to each other, are provided in the case (10), at least one of the first contact surface (23a) and the second contact surface (16a) being a front plate surface of the fixed conductive plate (20);
wherein the elastic conductive plate (30) comprises:
a first pressure contact portion (31), which is elastically pressed against the first contact surface (23a),
a second pressure contact portion (32), which is turned-backed from the first pressure contact portion (31) and is elastically pressed against the second contact surface (16a),
an elastic arm portion (34), which extends toward the fixed electrode portion (5), and
an elastically-pressed contact point, which is provided at a top of the elastic arm portion (34) and is elastically pressed against the fixed electrode portion (5);
at least one of the first pressure contact portion (31) and the second pressure contact portion (32) is in contact with the front plate surface of the fixed conductive plate (20);
the electronic device (1, 101, 201) being **characterized in that** the elastic conductive plate (30)
further comprises a support piece portion (33), which is bent from the second pressure contact portion (32) and extends beyond the first contact surface (23a),
the elastic arm portion (34) is bent from the support piece portion (33);
the elastic conductive plate (30) is integrally formed from a leaf spring metal material;
a linkage end (23c) is formed at part of the fixed conductive plate (20), and the linkage end (23c) and the support piece portion (33) of the elastic conductive plate (30) are fitted to each other to form a restricting portion (41, 42, 43) that restricts the support piece from separating from the fixed electrode portion (5).

2. The electronic device (1, 101, 201) having the fixed conductive plate (20) and elastic conductive plate (30) according to Claim 1, wherein: a hole (37) is formed in the support piece portion (33); and, in the restricting portion (41, 42, 43), the linkage end (23c) is fitted into the hole (37).

3. The electronic device (1, 101, 201) having the fixed conductive plate (20) and elastic conductive plate (30) according to Claim 2, wherein: at least one stop piece (38b, 38c) is formed by being cut and raised in the support piece portion (33); and, in the restricting portion (41, 42, 43), the top of the stop piece (38b, 38c) is stopped at the linkage end (23c) inserted into the hole (37).

4. The electronic device (1, 101, 201) having the fixed conductive plate (20) and elastic conductive plate (30) according to any one of Claims 1 to 3, wherein: a concave portion (16) opposite to the linkage end (23c) is formed in the case (10); and the top of the linkage end (23c) be inserted into the concave portion (16).

## Patentansprüche

1. Elektronische Vorrichtung (1, 101, 201) mit einer feststehenden leitfähigen Platte (20) und einer elastischen leitfähigen Platte (30), wobei die feststehende leitfähige Platte (20), von der ein Teil zu einem externen Anschlussbereich (21) wird, die elastische leitfähige Platte (30), die mit der feststehenden leitfähigen Platte (20) verbunden ist, sowie ein feststehender Elektrodenbereich (5), der elektrisch kontinuierlich zu der elastischen leitfähigen Platte (30) ist, in einem Gehäuse (10) vorgesehen sind;
wobei eine erste Kontaktfläche (23a) und eine zweite Kontaktfläche (16a), die einander gegenüberliegen, in dem Gehäuse (10) vorgesehen sind, wobei mindestens eine von der ersten Kontaktfläche (23a) und der zweiten Kontaktfläche (16a) eine vordere Plattenfläche der feststehenden leitfähigen Platte (20) ist;
wobei die elastische leitfähige Platte (30) aufweist:
einen ersten Druckkontaktbereich (31), der elastisch gegen die erste Kontaktfläche (23a) gedrückt ist,
einen zweiten Druckkontaktbereich (32), der von dem ersten Druckkontaktbereich (31) zurückgebogen ist und elastisch gegen die zweite Kontaktfläche (16a) gedrückt ist,
einen elastischen Armbereich (34), der sich in Richtung auf den feststehenden Elektrodenbereich (5) erstreckt, und
einen elastisch beaufschlagten Kontaktpunkt, der an einem oberen Ende des elastischen Armbereichs (34) vorgesehen ist und elastisch gegen den feststehenden Elektrodenbereich (5) gedrückt ist;
wobei mindestens einer von dem ersten Druckkontaktbereich (31) und dem zweiten Druckkontaktbereich (32) mit der vorderen Plattenfläche der feststehenden leitfähigen Platte (20) in Kontakt steht;
wobei die elektronische Vorrichtung (1, 101, 201) **dadurch gekennzeichnet ist,**
**dass** die elastische leitfähige Platte (30) ferner einen Stützstückbereich (33) aufweist, der von dem zweiten Druckkontaktbereich (32) umgebogen ist und sich über die erste Kontaktfläche (23a) hinaus erstreckt,
wobei der elastische Armbereich (34) von dem Stützstückbereich (33) umgebogen ist;
wobei die elastische leitfähige Platte (30) einstückig aus einem Blattfedermetallmaterial gebildet ist;
wobei ein Verbindungsende (23c) an einem Teil der feststehenden leitfähigen Platte (20) gebildet ist und das Verbindungsende (23c) und der Stützstückbereich (33) der elastischen leitfähigen Platte (30) aneinander gepasst sind, um einen Begrenzungsbereich (41, 42, 43) zu bilden, der das Trennen des Stützstücks von dem feststehenden Elektrodenbereich (5) unterbindet.

2. Elektronische Vorrichtung (1, 101, 201) mit der feststehenden leitfähigen Platte (20) und der elastischen leitfähigen Platte (30) nach Anspruch 1, wobei:
eine Öffnung (37) in dem Stützstückbereich (33) gebildet ist; und in dem Begrenzungsbereich (41, 42, 43) das Verbindungsende (23c) in die Öffnung (37) eingepasst ist.

3. Elektronische Vorrichtung (1, 101, 210) mit der feststehenden leitfähigen Platte (20) und der elastischen leitfähigen Platte (30) nach Anspruch 2, wobei:
mindestens ein Anschlagstück (38b, 38c) durch Schneiden und Anheben in dem Stützstückbereich (33) gebildet ist; und in dem Begrenzungsbereich (41, 42, 43) das obere Ende des Anschlagstücks (38b, 38c) an dem in die Öffnung (37) eingeführten Verbindungsende (23c) gestoppt ist.

4. Elektronische Vorrichtung (1, 101, 201) mit der feststehenden leitfähigen Platte (20) und der elastischen leitfähigen Platte (30) nach einem der Ansprüche 1 bis 3,
wobei:
ein konkaver Bereich (16) gegenüber dem Verbindungsende (23c) in dem Gehäuse (10) gebildet ist; und das obere Ende des Verbindungsendes (23c) zum Einsetzen in den konkaven Bereich (16) vorgesehen ist.

## Revendications

1. Dispositif électronique (1, 101, 201) ayant une plaque conductrice fixe (20) et une plaque conductrice élastique (30), dans lequel la plaque conductrice fixe (20), dont une partie devient une partie terminale externe (21), la plaque conductrice élastique (30) reliée à la plaque conductrice fixe (20), ainsi qu'une partie d'électrode fixe (5) présentant une continuité électrique avec la plaque conductrice élastique (30) sont situées dans un boîtier (10) ;
une première surface de contact (23a) et une deuxième surface de contact (16a), qui sont à l'opposé l'une de l'autre, sont situées dans le boîtier (10), au moins l'une de la première surface de contact (23a) et de la deuxième surface de contact (16a) étant une surface de plaque avant de la plaque conductrice fixe (20) ;
dans lequel la plaque conductrice élastique (30) comprend :
une première partie de contact par pression (31), qui est pressée de manière élastique contre la première surface de contact (23a),
une deuxième partie de contact par pression (32), qui est retournée par rapport à la première partie de contact par pression (31) et pressée de manière élastique contre la deuxième surface de contact (16a),
une partie de bras élastique (34), qui s'étend vers la partie d'électrode fixe (5), et
un point de contact pressé de manière élastique, qui se situe en haut de la partie de bras élastique (34) et est pressé de manière élastique contre la partie d'électrode fixe (5) ;
au moins l'une de la première partie de contact par pression (31) ou de la deuxième partie de contact par pression (32) est en contact avec la surface de plaque avant de la plaque conductrice fixe (20) ;
le dispositif électronique (1, 101, 201) étant **caractérisé en ce que**
la plaque conductrice élastique (30) comprend en outre une partie pièce de support (33) qui est pliée depuis la deuxième partie de contact par pression (32) et s'étend au-delà de la première surface de contact (23a),
la partie de bras élastique (34) est pliée depuis la partie pièce de support (33) ;
la plaque conductrice élastique (30) est intégralement formée à partir d'une feuille de matériau métallique à ressort ;
une extrémité de liaison (23c) est formée sur une partie de la plaque conductrice fixe (20), et l'extrémité de liaison (23c) et la partie pièce de support (33) de la plaque conductrice élastique (30) sont ajustées l'une à l'autre afin de former une partie limitante (41, 42, 43) qui empêche la pièce de support de se séparer de la partie d'électrode fixe (5).

2. Le dispositif électronique (1, 101, 201) ayant une plaque conductrice fixe (20) et une plaque conductrice élastique (30) selon la revendication 1, dans lequel : un trou (37) est formé dans la partie pièce de support (33) ; et, dans la partie limitante (41, 42, 43), l'extrémité de liaison (23c) est logée dans le trou (37).

3. Le dispositif électronique (1, 101, 201) ayant une plaque conductrice fixe (20) et une plaque conductrice élastique (30) selon la revendication 2, dans lequel : au moins une pièce d'arrêt (38b, 38c) est formée en étant coupée et soulevée dans la partie pièce de support (33) ; et, dans la partie limitante (41, 42, 43), le haut de la pièce d'arrêt (38b, 38c) est stoppé à l'extrémité de liaison (23c) insérée dans le trou (37).

4. Le dispositif électronique (1, 101, 201) ayant une plaque conductrice fixe (20) et une plaque conductrice élastique (30) selon l'une quelconque des revendications 1 à 3, dans lequel : une partie concave (16) opposée à l'extrémité de liaison (23c) est formée dans le boîtier (10) ; et le haut de l'extrémité de liaison (23c) est inséré dans la partie concave (16).
